# DEMANDE DE BREVET EUROPEEN

(11) **EP 2 400 548 A1**
(43) Date de publication de la demande: **28.12.2011**
(21) Numéro de dépôt: 11354032.2
(22) Date de dépôt: 14.06.2011
(51) Int. Cl.: H01L 27/12, H01L 21/84

(54) **Substrat muni d'une zone semi-condutrice associée à deux contre-électrodes et dispositif comportant un tel substrat**

(30) Priorité: 24.06.2010 FR 1002657
(71) Demandeur: Commissariat à l'Énergie Atomique et aux Énergies Alternatives, 75015 Paris (FR); STMicroelectronics (Crolles 2) SAS, 38920 Crolles (FR)
(72) Inventeur: Coronel, Philippe, 38530 Barraux (FR); Fenouillet-Béranger, Claire, 38000 Grenoble (FR); Denorme, Stéhane, 38920 Crolles (FR); Thomas, Olivier, 38420 Revel (FR)
(74) Mandataire: Talbot, Alexandre

(57) **Abrégé**

Un substrat de support (2) comporte des première et seconde contre-électrodes (5) disposées dans un même plan, au niveau d'une face du substrat de support (2). Une zone électriquement isolante (9) sépare les première et seconde contre-électrodes (5). Une zone semi-conductrice (7) avec des première et seconde portions est séparée du substrat de support (2) par un matériau électriquement isolant (3). Le matériau électriquement isolant (3) est différent du matériau formant le substrat de support (2). La première portion de la zone semi-conductrice (7) fait face à la première contre-électrode (5). La seconde portion de la zone semi-conductrice (7) fait face à la seconde contre-électrode (5).

## Description

### Domaine technique de l'invention

L'invention est relative à un substrat muni d'une zone active séparée d'un substrat de support par une couche électriquement isolante et au procédé de réalisation de ce substrat.

### État de la technique

Afin de pallier des effets parasites de plus en plus présents, les dispositifs à effet de champ ont incorporé une contre-électrode, c'est-à-dire une seconde électrode qui présente un effet électrostatique sur le canal de conduction.

Cette architecture est associée généralement aux dispositifs réalisés sur des substrats de type semi-conducteur sur isolant dans lesquels une couche en matériau semi-conducteur est séparée d'un substrat de support par un matériau diélectrique enterré.

Si le substrat de support est conducteur ou s'il présente une zone ayant une conductivité suffisante, il est possible d'assimiler ce substrat à une quasi électrode de grille. Les matériaux et les dimensions de cette architecture n'étant pas optimisés, il ne s'agit pas d'une seconde électrode de grille mais d'une électrode qui est en mesure de modifier les performances du dispositif à effet de champ.

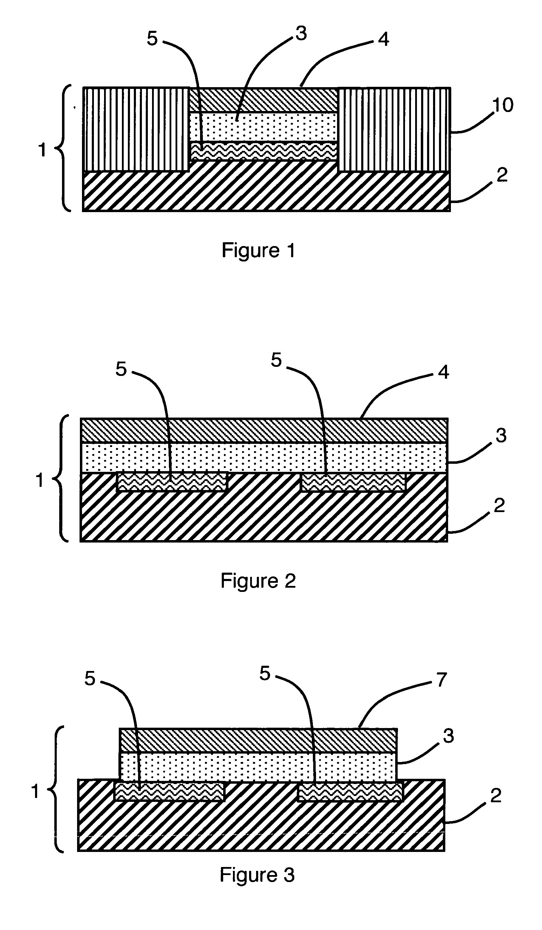

Comme illustré à la figure 1, le substrat 1 comporte un substrat de support 2 recouvert par une couche en matériau isolant 3 et une couche 4 en matériau semi-conducteur. Le substrat de support 2 comporte une contre-électrode 5 qui fait face à une zone active de la couche 4 en matériau semi-conducteur. La zone active en matériau semi-conducteur et sa contre-électrode associée sont entourées par un motif d'isolation 9 afin de limiter l'influence de la contre-électrode sur les dispositifs adjacents et éviter les fuites avec les autres contre-électrodes.

Même si ce dispositif présente de nombreux avantages, il est associé à une complexité de réalisation accrue car il existe une électrode supplémentaire. Par ailleurs, certaines applications sont difficilement réalisables avec des transistors à contre-électrode.

Dans les cellules mémoires, il est important d'avoir la plus grande compacité possible. Afin d'obtenir ce résultat, le positionnement des différents transistors ainsi que la forme des multiples briques technologiques telles que le dessin de la grille ou le dessin de la zone active est l'objet de nombreuses études. Dans ces conditions, l'utilisation d'un transistor à contre-électrode est extrêmement complexe à mettre en place.

### Objet de l'invention

On constate qu'il existe un besoin de prévoir un substrat qui comporte une zone active associée de manière compacte à une pluralité de futures contre-électrodes.

Le dispositif selon l'invention est caractérisé par les revendications annexées et en particulier par le fait qu'il comporte :
- un substrat de support,
- des première et deuxième contre-électrodes disposées dans un même plan, au niveau d'une face du substrat de support,
- une zone électriquement isolante séparant les première et deuxième contre-électrodes,
- une zone semi-conductrice, comprenant des première et deuxième portions
- la première portion de la zone semi-conductrice faisant face à la première contre-électrode,
- la deuxième portion de la zone semi-conductrice faisant face à la deuxième contre-électrode,
- un matériau électriquement isolant séparant la zone semi-conductrice du substrat de support, le matériau électriquement isolant étant différent du matériau formant le substrat de support.

On constate également qu'il existe un besoin de prévoir un procédé de réalisation d'un substrat qui soit facile à mettre en oeuvre.

Le procédé est caractérisé par les revendications annexées et en particulier par le fait qu'il comporte les étapes suivantes :
- prévoir un substrat de support recouvert successivement par une couche isolante et une couche semi-conductrice,
- prévoir un matériau de contre-électrode disposé, au niveau d'une face du substrat de support et recouvert par la couche isolante et la couche semi-conductrice,
- graver la couche semi-conductrice et la couche isolante pour laisser, dans la couche semi-conductrice, une zone semi-conductrice faisant face au matériau de contre-électrode,
- graver une partie du substrat de support face à la zone semi-conductrice de manière à former une zone électriquement isolante séparant deux parties du matériau de contre-électrode

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- La figure 1 représente, de manière schématique, en coupe, une zone active associée à une contre-électrode selon l'art antérieur,
- les figures 2, 3 et 5 à 7 représentent, de manière schématique, en coupe selon AA, différentes étapes d'un premier procédé de réalisation d'un substrat,
- la figure 4 représente, de manière schématique, en vue de dessus, un substrat selon la figure 3,
- les figures 8 à 10 représentent, de manière schématique, en coupe selon AA, différentes étapes d'un second procédé de réalisation d'un substrat,
- la figure 11 représente, de manière schématique, en coupe selon BB, un substrat selon la figure 10,
- la figure 12 représente, de manière schématique, en coupe selon AA, des transistors intégrés sur un substrat.

### Description d'un mode de réalisation préférentiel de l'invention

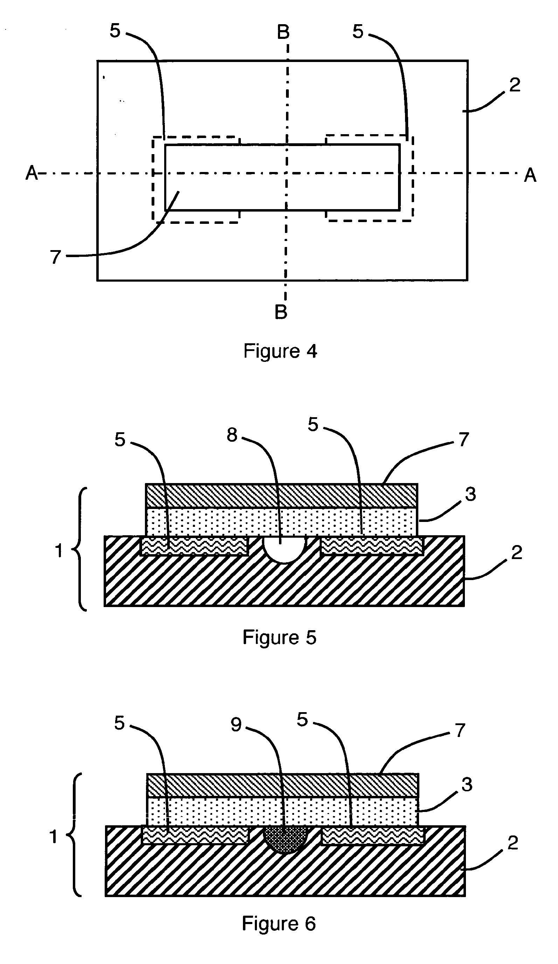

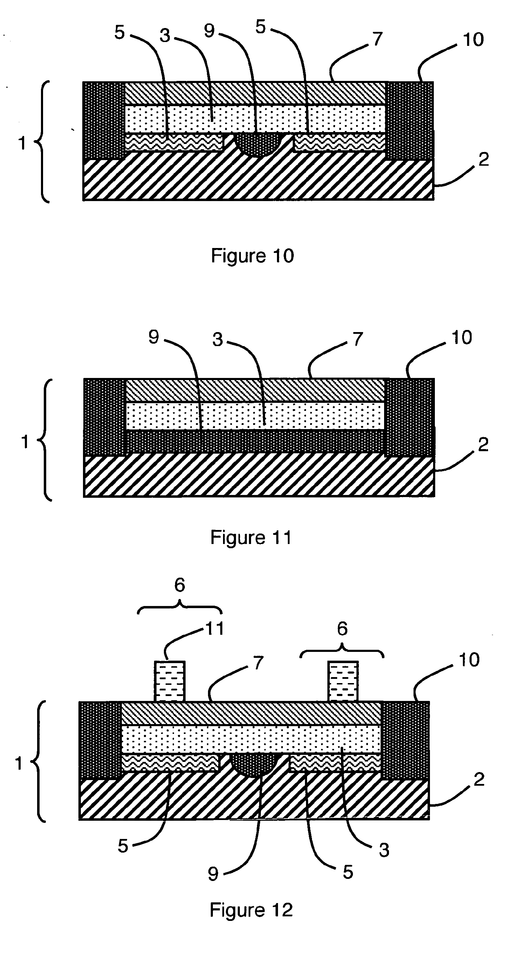

Les figures 2, 3, 5 à 10 et 12 représentent une vue de coupe selon l'axe AA de la figure 4. La figure 11 représente une vue de coupe selon l'axe BB de la figure 4.

Comme cela est illustré à la figure 2, le substrat 1 initial est de type semi-conducteur sur isolant et comporte un substrat de support 2, une couche isolante 3 en matériau électriquement isolant, une couche active 4 en matériau semi-conducteur. La couche isolante 3 en matériau électriquement isolant sépare le substrat de support 2 de la couche active 4 en matériau semi-conducteur. Le substrat de support 2 est, par exemple, un substrat en silicium ou un autre substrat en matériau semi-conducteur monocristallin ou polycristallin. Le matériau électriquement isolant de la couche isolante 3 est un matériau différent de celui du substrat de support 2.

Le substrat de support 2 comporte une contre-électrode 5 ou une pluralité de contre-électrodes 5, typiquement deux contre-électrodes ou plus. Une contre-électrode 5 est une zone de faible résistivité comparée au reste du substrat de support 2. Une contre-électrode 5 peut être formée par dopage du substrat de support 2 ou par intégration d'un matériau plus conducteur, par exemple un matériau métallique sur la surface ou dans le substrat de support 2.

Le substrat de support 2 peut également comporter un matériau de contre-électrode, c'est-à-dire un matériau apte à former une contre-électrode 5 ou à être modifié pour former une contre-électrode 5. Si le substrat de support 2 est en silicium, il est formé dans un matériau de contre-électrode car il suffit de doper ce dernier pour créer une ou plusieurs contre-électrodes 5. La contre-électrode 5 peut donc être formée à différents stades du procédé d'élaboration. De ce fait, la description traite de contre-électrodes 5 déjà formées afin de faciliter la compréhension bien qu'il soit possible de former ces contre-électrodes plus tard dans le procédé.

Une contre-électrode 5 peut être associée à un transistor 6 à effet de champ ou à une pluralité de transistors 6 à effet de champ (voir figure 12). La contre-électrode 5 formée dans le substrat de support 2 est caractérisée par sa surface d'action, c'est-à-dire sa surface dans un plan d'interface parallèle à l'interface entre le substrat de support 2 et la couche isolante 3. Elle est également caractérisée par son épaisseur, c'est-à-dire sa dimension dans la direction perpendiculaire à ce plan d'interface. Elle est encore caractérisée par sa profondeur, c'est-à-dire sa distance la plus courte jusqu'à une portion d'un zone semi-conductrice 7 associée (représentée en figure 3).

De manière préférentielle, les deux contre-électrodes 5 présentent la même épaisseur et la même profondeur, cependant, selon les aléas du procédé de fabrication ou selon les besoins, il est possible d'avoir des contre-électrodes 5 avec des caractéristiques différentes tant du point de vue de la profondeur de la contre-électrode 5 que du point de vue de son épaisseur. De ce fait, il est envisageable d'avoir deux contre-électrodes 5 qui ont des épaisseurs différentes c'est-à-dire qui appartiennent à deux plans différents, chaque plan étant parallèle à la surface du substrat.

Les deux électrodes ne sont pas l'une sur l'autre, mais l'une à côté de l'autre, c'est-à-dire qu'elles sont décalées latéralement. Il est alors possible de considérer que les contre-électrodes définissent un plan qui n'est pas obligatoirement parallèle au plan contenant la zone semi-conductrice.

Comme illustré à la figure 3, la couche semi-conductrice 4 et la couche isolante 3 sont structurées, par toute technique de gravure adaptée, pour former une zone en saillie à la surface du substrat de support 2. La structuration de la couche semi-conductrice 4 laisse subsister dans cette couche 4 une zone active semi-conductrice 7 en matériau semi-conducteur. Cette zone active 7 est dans le même matériau que la couche semi-conductrice 4.

La zone semi-conductrice 7 est, de préférence monocristalline, c'est-à-dire qu'elle est formée par un seul cristal. Il y a donc continuité de la maille cristalline d'un bout à l'autre de la zone semi-conductrice 7. La zone active 7 est séparée du substrat de support 2 par la couche isolante 3.

La couche isolante 3 est également structurée selon un dessin identique ou proche de celui de la zone active 7. La structuration (par exemple par gravure) de la couche isolante 3 permet de découvrir une partie du substrat de support 2. La structuration de la couche semi-conductrice 4 et de la couche isolante 3 peut également découvrir partiellement une ou plusieurs contre-électrodes 5.

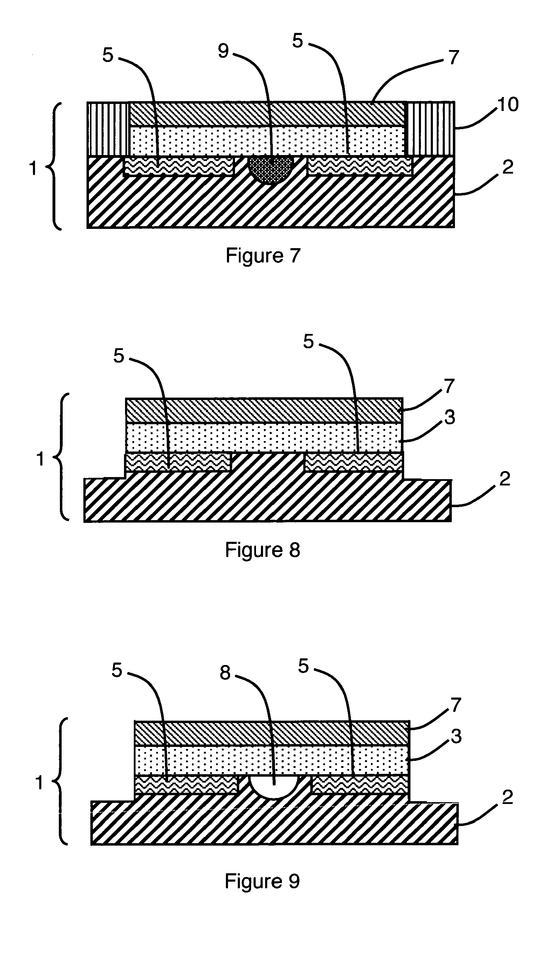

Si la structuration de la couche isolante 3 est prolongée dans le substrat de support 2, les portions de contre-électrodes 5 découvertes peuvent être éliminées ce qui permet d'autoaligner les bords extérieurs de la zone active 7 et de la contre-électrode associée, comme illustré à la figure 8.

Lors de la gravure de la couche semi-conductrice 4 et de la couche isolante 3, il y a formation d'une zone active protubérante depuis le substrat du support 2.

Comme cela est illustré à la figure 4, en vue de dessus, la zone active semi-conductrice 7 fait face à une ou deux contre-électrodes 5 du substrat de support 2, c'est-à-dire qu'elles sont en vis-à-vis. Ainsi, au moins une contre-électrode 5 est recouverte au moins partiellement par une portion de la couche isolante 3 et une partie de la zone active 7.

Comme illustré à la figure 5, le substrat de support 2 est ensuite gravé de manière à former une zone vide électriquement isolante 8 entre deux parties du matériau de contre-électrodes dans le substrat de support 2, sous la zone active, c'est-à-dire entre deux futures contre-électrodes. Cette structuration est réalisée par toute technique adaptée, typiquement au moyen d'une gravure isotrope. Selon la nature du matériau à éliminer par rapport aux autres matériaux en présence, différentes approches sont possibles. Le matériau à éliminer peut être le matériau formant le substrat de support et/ou le matériau de contre-électrode 5 qu'il soit également ou non le matériau formant le substrat de support 2.

Dans un premier mode de réalisation particulier, la gravure localisée du substrat de support 2 est réalisée par transformation d'une partie du matériau présent à la surface du substrat de support 2. Cette transformation permet par la suite de réaliser une gravure sélective de ce nouveau matériau par rapport à celui formant initialement le substrat de support 2 et/ou le matériau de contre-électrode. Cette transformation est réalisée, par exemple, par implantation d'un matériau dopant qui est électriquement actif ou non. Cette transformation autorise l'emploi d'une chimie de gravure sélective vis-à-vis des matériaux présents.

Dans un second mode de réalisation particulier, une partie de la surface du substrat de support 2 est protégée au moyen d'un masque de protection. La partie du matériau du substrat de support 2 et/ou de la contre-électrode qui est laissée découverte est éliminée, par la suite, au moyen d'un agent de gravure. Cette gravure isotrope peut être obtenue, par exemple, par voie liquide ou par voie gazeuse.

La structuration du substrat de support 2 permet d'éliminer ce dernier dans une partie située entre deux portions de matériau de contre-électrode, notamment sous la zone active. Cette étape permet d'éliminer ou de réduire la connexion électrique directe entre les deux contre-électrodes 5.

Selon les potentiels appliqués aux contre-électrodes 5, l'étendue de la zone vide électriquement isolante 8 peut varier afin de bloquer les lignes de champ. Si des potentiels importants sont appliqués, la zone vide peut s'étendre plus profondément que les deux contre-électrodes 5. La zone vide s'étend au moins depuis l'interface avec la couche en matériau électriquement isolant jusqu'à une profondeur équivalente à celle de la contre-électrode la plus profonde.

Dans un mode de réalisation particulier non représenté, la zone vide électriquement isolante 8 peut être couplée à des moyens de blocage additionnels des courants parasites. A titre d'exemple, ces moyens de blocage prennent la forme de zones dopées dans le substrat de support 2 semi-conducteur. Il y a alors formation d'une ou plusieurs diodes qui bloquent les courants de court-circuit. Avantageusement, ces zones dopées sont formées par implantation ionique.

Dans une variante de réalisation qui peut être combinée avec les modes de réalisation précédents, la couche isolante 3 est partiellement éliminée.

Comme illustré à la figure 6, la zone vide électriquement isolante 8 sous la zone semi-conductrice 7 peut être remplie par un matériau isolant électriquement, par exemple, un oxyde de silicium, un nitrure de silicium ou un isolant à plus haute constante diélectrique tel que HfO₂ Pour former une zone pleine électriquement isolante 9. Le matériau isolant électriquement est déposé de manière à remplir au moins partiellement la zone vide. De façon avantageuse, le matériau isolant est ensuite structuré de façon à être localisé dans des zones intéressantes, typiquement sous la zone active qui sépare les deux contre-électrodes.

Dans un mode de réalisation particulier illustré à la figure 7, un motif d'isolation 10 est formé afin d'améliorer la tenue mécanique de la structure et l'isolation électrique. Le motif d'isolation 10 entoure la zone active 7. Il forme, autour de la zone active 7, un motif périphérique fermé qui recouvre le substrat de support 2 et les parois latérales de la zone active 7 et de la couche isolante 3.

Dans un mode de réalisation particulier pouvant être combiné avec les modes précédents et illustré à la figure 8, la structuration de la couche semi-conductrice 4 et de la couche isolante 3 est poursuivie par la structuration de la partie supérieure du substrat de support 2. De cette manière, une zone en saillie du substrat de support 2 est formée ainsi qu'un accès aux faces latérales de cette zone en saillie pour former la zone 8 électriquement isolante.

Dans un mode de réalisation préférentiel, la gravure du substrat de support 2 est réalisée depuis des faces latérales opposées de la zone en saillie du substrat de support 2. Ceci permet de réduire le temps de gravure et ainsi la gravure parasite dans les autres directions. Il est également possible de réaliser la gravure depuis un seul côté de la structure en saillie.

Comme cela est illustré à la figure 9, une fois la gravure partielle du substrat de support 2 réalisée, la zone active est toujours solidaire du substrat de support 2, mais elle comporte une zone désolidarisée du substrat de support 2, une zone suspendue. Au moyen de la zone vide créée dans le substrat de support 2, il n'y a plus de contact électrique direct entre les deux contre-électrodes, ce qui permet selon les cas d'éliminer ou de réduire les courts-circuits. Cette zone vide forme une zone électriquement isolante 8 qui découvre une partie de l'interface entre la couche isolante 3 et le substrat de support 2 et qui sépare les deux contre-électrodes 5. Dans ce cas, la zone électriquement isolante 8 est séparée de la zone semi-conductrice 7 par la couche isolante 3.

Dans une variante de réalisation illustrée à la figure 10 et qui peut être combinée avec les modes précédents, le matériau isolant électriquement de la zone 9 est le même que celui qui peut être utilisé pour le motif d'isolation 10. Le matériau isolant électriquement remplit la zone isolante 8 sous la zone active et il forme le motif d'isolation 10 tout autour de la zone active 7. La formation du motif d'isolation 10 et le remplissage de la zone électriquement isolante 9 sont simultanés.

De cette manière, on obtient une zone active 7 monobloc, avantageusement monocristalline, qui est entourée par un motif d'isolation 10 périphérique fermé. Cette zone active 7 est associée à au moins deux contre-électrodes 5, indépendantes électriquement, disposées sur une face du substrat de support 2. Chacune des contre-électrodes 5 fait face à une portion particulière de la zone active 7. Ici, la première portion fait face à la première contre-électrode 5 et la seconde portion fait face à la seconde contre-électrode 5. Les deux portions de la zone active 7 sont dans un même plan et sont décalées latéralement l'une par rapport à l'autre.

La séparation électrique des contre-électrodes est obtenue au moyen de la zone électriquement isolante 8, 9 qui sépare les contre-électrodes. De ce fait l'étendue latérale de la zone 8, 9 selon la direction BB est au moins égale à celle des contre-électrodes. Cette séparation électrique peut être améliorée au moyen du motif d'isolation 10 qui entoure la zone active 7 et qui peut donc entourer partiellement (verticalement) les contre-électrodes 5 au niveau des parois latérales. Le motif d'isolation 10 peut présenter une profondeur d'enfoncement dans le substrat de support différente de celle de la zone isolante électriquement 8, 9. Dans ce cas, chacune des deux contre-électrodes 5 est entourée par un matériau électriquement isolant fermé et périphérique. L'épaisseur du motif d'isolation 10 autour de la zone semi-conductrice 7 est différente de l'épaisseur du matériau électriquement isolant sous la zone semi-conductrice 7. Comme illustré à la figure 11 dans une coupe selon le plan BB, la zone électriquement isolante 9 rejoint le motif d'isolation 10.

Une fois la zone active formée et les contre-électrodes formées, il est possible de former des transistors à effet de champ, de manière conventionnelle. A titre d'exemple illustré à la figure 12, des premier et second transistors 6 sont formés sur la zone active 7.

Chaque transistor 6 comporte, de manière classique, une électrode de grille 11 et deux électrodes de source/drain (non représentées). Les électrodes de source/drain sont formées dans la zone active de part et d'autre de l'électrode de grille.

Le premier transistor 6 comporte une première électrode de grille 11, un premier canal de conduction et une des contre-électrodes 5, la première contre-électrode. Le second transistor 6 comporte une seconde électrode de grille 11, un second canal de conduction et l'autre des contre-électrodes, la seconde contre-électrode 5. Chaque électrode de grille est séparée du canal de conduction par un isolant de grille.

Chaque canal de conduction est disposé entre son électrode de grille 11 et sa contre-électrode 5 associée. Chaque canal de conduction est séparé de l'électrode de grille 11 et de la contre-électrode 5 par un matériau qui est isolant électriquement, l'isolant de grille pour l'électrode de grille 11 et la couche isolante 3 pour la contre-électrode 5. Chaque contre-électrode 5 a un effet électrostatique sur son canal de conduction associé. Les première et seconde contre-électrodes 5 sont avantageusement disposées dans un même plan, au niveau d'une face du substrat de support 2 ce qui permet de simplifier le procédé de réalisation.

Dans ce dispositif, une zone active 7 est associée à deux transistors 6 différents, par exemple deux transistors connectés en série, et chaque transistor possède sa propre contre-électrode 5. Le contact de contre-électrode est réalisé indépendamment pour chaque contre-électrode 5 afin d'assurer leur indépendance électrique.

Dans un mode de réalisation particulier, il est avantageux de former une seule contre-électrode 5 avant la formation de la zone électriquement isolante 8, 9. Cette contre-électrode a un dessin en rapport avec celui de la zone active. La contre-électrode est ensuite structurée lors de la gravure partielle du substrat de support 2 pour former une pluralité de contre-électrodes, ici des première et seconde contre-électrodes 5.

Au final, il existe une zone active 3 commune avec deux dispositifs 6. Chacun de ces deux dispositifs 6 est associé à une contre-électrode 5 spécifique, c'est-à-dire que chaque contre-électrode 5 fait face à son dispositif 6 associé. Les contre-électrodes 5 sont isolées électriquement l'une de l'autre au moins par la zone électriquement isolante 8, 9. De cette manière, une zone active munie d'au moins deux dispositifs actifs peut également comporter des contre-électrodes électriquement dissociées grâce à la zone électriquement isolante 8, 9.

Dans un mode de réalisation particulier, la zone électriquement isolante 8, 9 est autoalignée par rapport aux futurs transistors. Dans ce mode de réalisation, la zone active 7 en saillie est formée et entourée par le motif d'isolation 10. Les électrodes de grille 11 sont ensuite formées sur la zone active 7 et une partie du motif d'isolation 10.

Des espaceurs latéraux à la dimension désirée sont réalisés et viennent définir la future position de la zone électriquement isolante 8, 9. Le motif d'isolation 10 est gravé par rapport aux espaceurs latéraux pour libérer l'accès à une partie du substrat de support. La zone électriquement isolante est formée dans le substrat de support 2.

Le reste du procédé est identique à ce qui a été présenté plus haut. Ainsi, la position latérale de la zone électriquement isolante 8, 9 est définie entre les électrodes de grille 11 au moyen d'espaceurs latéraux et par rapport aux électrodes de grille 11.

## Revendications

1. Substrat (1) **caractérisé en ce qu'**il comporte :
- un substrat de support (2),
- des première et deuxième contre-électrodes (5) disposées dans un même plan, au niveau d'une face du substrat de support (2),
- une zone électriquement isolante (8, 9) séparant les première et deuxième contre-électrodes (5),
- une zone semi-conductrice monobloc (7), comprenant des première et deuxième portions,
- la première portion de la zone semi-conductrice faisant face à la première contre-électrode (5),
- la deuxième portion de la zone semi-conductrice faisant face à la deuxième contre-électrode (5),
- un matériau électriquement isolant (3) séparant la zone semi-conductrice (7) du substrat de support (2), le matériau électriquement isolant (3) étant différent du matériau formant le substrat de support (2).

2. Substrat selon la revendication 1, **caractérisé en ce que** la zone semi-conductrice (7) est monocristalline.

3. Substrat selon l'une des revendications 1 et 2, **caractérisé en ce que** la zone semi-conductrice (7) est entourée par un motif d'isolation (10) en matériau électriquement isolant.

4. Substrat selon l'une des revendications 2 et 3, **caractérisé en ce que** l'épaisseur du motif d'isolation (10) autour de la zone semi-conductrice (7) est différente de l'épaisseur du matériau électriquement isolant sous la zone semi-conductrice (7).

5. Substrat selon l'une quelconque des revendications 1 à 4, **caractérisé en ce que** la zone électriquement isolante (8, 9) est séparée de la zone semi-conductrice (7) par la couche isolante (3).

6. Dispositif semi-conducteur comportant :
- un premier et un deuxième transistors (6) à effet de champ disposés sur un substrat (1) selon l'une quelconque des revendications 1 à 5,
- le premier transistor (6) étant muni d'un premier canal de conduction et d'une première électrode de grille (11) faisant face à la première contre-électrode (5),
- le deuxième transistor (6) étant muni d'un deuxième canal de conduction et d'une deuxième électrode de grille (11) faisant face à la deuxième contre-électrode (5).

7. Procédé de réalisation d'un substrat **caractérisé en ce qu'**il comporte les étapes suivantes :
- prévoir un substrat de support (2) recouvert successivement par une couche isolante (3) et une couche semi-conductrice (4),
- prévoir un matériau de contre-électrode disposé, au niveau d'une face du substrat de support (2) et recouvert par la couche isolante (3) et la couche semi-conductrice (4),
- graver la couche semi-conductrice (4) et la couche isolante (3) pour laisser, dans la couche semi-conductrice (4), une zone semi-conductrice monobloc (7) faisant face au matériau de contre-électrode,
- graver une partie du substrat de support (2) face à la zone semi-conductrice (7) de manière à former une zone électriquement isolante (8) séparant deux parties du matériau de contre-électrode.

8. Procédé selon la revendication 7 **caractérisé en ce qu'**il comporte l'étape de former un motif d'isolation (10) entourant la zone semi-conductrice (7) et remplissant la zone électriquement isolante (9).

9. Procédé selon la revendication 8 **caractérisé en ce qu'**il comporte les étapes de former deux électrodes de grille sur la zone active (7) et le motif d'isolation (10) et de former des espaceurs latéraux définissant l'emplacement de la zone électriquement isolante (8, 9) entre les deux électrodes de grilles (11).
